# EUROPEAN PATENT APPLICATION

(11) **EP 4 848 595 A1**
(43) Date of publication of application: **02.12.2026**
(21) Application number: 26181641.7
(22) Date of filing: 28.05.2026
(51) Int. Cl.: H03M 13/15, H03M 13/29

(54) **FOLDED TURBO PRODUCT CODES**

(30) Priority: 28.05.2025 US 202563813483 P; 26.05.2026 US 202619687766
(71) Applicant: Marvell Asia Pte Ltd, Singapore 369522 (SG)
(72) Inventor: Barakatain, Masoud, San Jose, CA, 95128 (US); Trasobares, Fernando, Cordoba (AR); Castrillon, Mario Alejandro, Cordoba (AR); Pang, Chin-Jen, Santa Clara, CA, 95050 (US); Morero, Damian Alfonso, Cordoba (AR); Riani, Jamal, Best (NL)
(74) Representative: Grünecker Patent- und Rechtsanwälte PartG mbB

(57) **Abstract**

Folded forward error-correction codes may reduce buffering and decoding latency by arranging payload information as rows and grouped columns of a folded product-code structure. In one example, encoded data includes payload information and parity information, where the parity information includes row parity information for rows of the payload information and grouped-column parity information for groups of two or more columns of the payload information. A decoder may begin decoding a grouped-column codeword after payload information for a smaller row dimension has been received than would be used in a corresponding conventional product codeword. In some examples, parity-on-parity information is omitted, which may reduce overhead, memory usage, and implementation complexity.

## Description

### Priority Application

This patent application claims priority to and/or receives benefit from U.S. Provisional Application No. 63/813,483, titled "Folded Turbo Product Codes (fTPC)," filed on May 28, 2025. The U.S. Provisional Application is hereby incorporated by reference in its entirety.

### Background

Forward error correction adds structured redundancy to transmitted or stored data so a receiver can detect and correct some errors, trading extra parity overhead and processing latency for improved reliability. Implementations span block and convolutional style codes, and decoding can use hard decisions on bits or soft decisions that incorporate reliability information such as log-likelihood ratios. In higher-performance receivers, iterative decoding and reliability updates can be used to improve coding gain while managing throughput, power, and area.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 illustrates an exemplary electronics system, according to some examples of the disclosure.
FIG. 2 illustrates an example communication system including an optical module, according to some examples of the disclosure.
FIG. 3 illustrates an exemplary transceiver architecture in which the encoding and decoding of folded product codes may be implemented, according to some examples of the disclosure.
FIG. 4A illustrates an exemplary implementation of FEC decoder circuitry that may be used to decode data encoded in accordance with a folded error-correction code, according to some examples of the disclosure.
FIG. 4B illustrates an example of folded turbo product code (fTPC) decoder circuitry of FIG. 4A, according to some examples of the disclosure.
FIG. 4C illustrates an example of the FEC decoder core of FIG. 4B, according to some examples of the disclosure.
FIG. 5 illustrates an example of the FEC encoder circuitry that may be used to encode data in accordance with a folded error-correction code, according to some examples of the disclosure.
FIGS. 6A-6C illustrate exemplary bit arrangements for product-code-based forward error correction, according to some examples of the disclosure.
FIGS. 7A-7B illustrate examples of folded TPC blocks, according to some examples of the disclosure.
FIG. 8 depicts a flow chart illustrating a method of decoding encoded data encoded in accordance with a folded error-correction code, according to some embodiments of the disclosure.
FIG. 9 depicts a flow chart illustrating a method of encoding payload information in accordance with a folded error-correction code, according to some embodiments of the disclosure.

### Detailed Description

### Overview

As serial link data rates and throughput per lane increase, receivers operate with reduced margin and heightened sensitivity to channel noise, non-linearities, and hardware impairments introduced by higher-speed signaling. These effects can raise raw error rates and variability across operating conditions, creating pressure to improve error-control capability while preserving throughput and implementation efficiency.

Soft-decision forward error correction (FEC) schemes with iterative decoding can offer improved error-rate performance, but practical deployment is constrained by overhead, latency, memory footprint, power, and silicon area. Overhead is particularly costly at high bit rates because additional parity directly reduces net payload throughput and can propagate to system-level bandwidth and power penalties. Latency is also a constraint for latency-sensitive applications, where buffering and multi-stage processing may increase end-to-end delay.

More specifically, some error-correction constructions that buffer large blocks of bits prior to encoding or decoding can require collecting and storing a large number of bits before processing, which contributes to higher latency and larger memory requirements. In addition, some constructions include additional redundancy that increases the total number of transmitted bits and decoding operations. These characteristics can make it challenging to achieve a favorable tradeoff among coding gain, overhead, latency, and implementation cost.

In examples described herein, folded turbo product codes may enable reduced latency and reduced memory footprint, for example, by organizing payload bits as a matrix in which the FEC processes row component codewords formed from bits of a row and processes grouped-column component codewords formed from bits spanning a group of columns, such that, in some implementations, a smaller amount of data may be buffered before encoding or decoding is initiated. In some examples, the forward error correction techniques may reduce overhead by omitting checks-on-checks (parity-on-parity) for parity bits while still providing payload protection via the row and grouped-column component codes.

### Exemplary electronics system

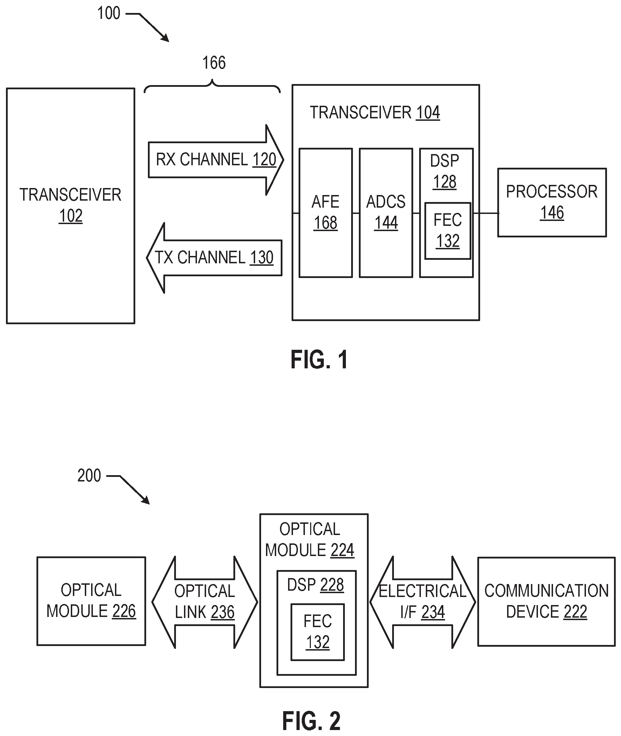

FIG. 1 illustrates an exemplary electronics system 100, according to some examples of the disclosure. The electronics system 100 may be used in high-speed, high-bandwidth communication applications. The electronics system 100 may include one or more components to carry out functionalities, including, among other things, effective signal transmission, reception, diagnostics, clock recovery, and forward error correction functionality. The electronics system 100 includes the transceiver 102 and the transceiver 104. The transceiver 104 can carry out communication functionalities for the processor 146. For simplicity, the processor for which the transceiver 102 is carrying out communication functionalities is omitted from FIG. 1.

The processor 146 may perform data processing tasks. The processor 146 can include one or more suitable types of processors, and one or more suitable number of processors. The processor 146 may be a single-core processor, or a multi-core (e.g., ARM or x86 processor cores). Examples of the processor 146 may include a central processing unit (CPU), a graphics processing unit (GPU), a field-programmable gate array (FPGA), a tensor processing unit (TPU), a data processing unit (DPU), a digital signal processor, an application-specific integrated circuit (ASIC), etc. The processor 146 can execute instructions or commands of an operating system. The processor 146 can perform operations and/or computations for an application of the electronics system 100. In some examples, the processor 146 may additionally configure or control one or more operations of the transceiver 104. In some examples, the processor 146 may represent, or may be included within, a communication device, such as a host system, a switch, a network interface controller (NIC), an accelerator, or other electronic device configured to communicate with the transceiver 104.

The transceiver 104 can enable transmission and reception of signals over the communication link 166. In this example, the communication link 166 can include one or more of: the RX channel 120, and the TX channel 130. The RX channel 120 can have one or more RX data lanes. The TX channel 130 can have one or more TX data lanes. In some examples, the communication link 166 may include one or more electrical communication channels, one or more optical communication channels, or combinations thereof.

The transceiver 102 can transmit data over the RX channel 120 to the transceiver 104 and can include circuitry to support transmission of data. Incoming data signals transmitted over the RX channel 120 can be received by the transceiver 104. The transceiver 104 has circuitry that processes the received data signals. The transceiver 104 can include the analog front-end (AFE) 168, which may include one or more amplifiers or other analog circuits to process the received data signals before the data signals are provided to the ADC circuitry 144. The ADC circuitry 144 can digitize the analog signals and output digital outputs or digital samples for further processing by the DSP 128 and the FEC circuitry 132. For high-speed, high-bandwidth data interfaces, the ADC circuitry 144 may, in some examples, include time-interleaved ADCs used to sample an analog signal received on the RX channel 120 to achieve the baud rate of the communication channel. The time-interleaved ADC circuitry 144 can take turns, one after another, or in a randomized fashion, to sample the received analog signal at different sampling points to produce the digitized samples of the received analog signal.

The transceiver 104 can transmit signals to the transceiver 102 via the TX channel 130, and the transceiver 104 can include additional circuitry to prepare data signals to be transmitted over the TX channel 130. The transceiver 104 can include TX circuitry to ensure faithful signal transmission over the communication link 166. In some examples, such TX circuitry may include one or more encoding, equalization, modulation, filtering, or signal conditioning functions.

The DSP 128 can manage data processing tasks within the transceiver 104. The DSP 128 can include circuitry to perform one or more operations or computations. The DSP 128 can include circuitry that can execute instructions to carry out such operations or computations. Examples of operations or computations can include, but are not limited to, diagnostics, control algorithms, signal processing, filtering, decision making or slicing, and equalization. The FEC circuitry 132 may perform one or more forward error correction operations, including encoding, decoding, error detection, error correction, or combinations thereof. In some examples, the FEC circuitry 132 may be implemented as part of the DSP 128, and in some examples, the FEC circuitry 132 may be implemented as separate circuitry. In some implementations, the FEC circuitry 132 may support one or more error-correction schemes, including, for example, folded product codes in which a column codeword is formed from bits spanning a group of columns. In an illustrative example, the scheme may iteratively process row and grouped-column codewords and, in some examples, may omit parity-on-parity for parity bits to reduce overhead.

While the description is focused on the transceiver 104, it is envisioned that various examples described herein are applicable to the transceiver 102. The disclosed examples are applicable to receivers, transmitters, and transceivers, and are not limited to any particular communication device configuration. In some examples, the transceiver 102 and/or the transceiver 104 may be implemented in or as part of an optical module, and the communication link 166 may include an optical communication channel. FIG. 2 illustrates an example in which forward error correction circuitry is implemented in an optical communication system or optical module.

### Exemplary communication system including an optical module

FIG. 2 illustrates an example communication system 200 including an optical module 224. The communication system 200 may include an optical module 224, a communication device 222, and a remote optical module 226 coupled via an optical link 236. The optical module 224 may be configured to exchange electrical signals with the communication device 222 via an electrical interface 234, and to transmit and receive optical signals over the optical link 236.

The communication device 222 may be configured to exchange data with the optical module 224 via the electrical interface 234. The communication device 222 may include one or more systems, devices, or circuits configured to generate, process, transmit, or receive data. In some examples, the communication device 222 may represent a computing system, networking system, or other electronic system or device configured to communicate with the optical module 224.

In some examples, the communication device 222 may include one or more processing elements and associated circuitry configured to process data and interface with the optical module 224. For example, the communication device 222 may include a processor corresponding to the processor 146 described with respect to FIG. 1. The processor may generate transmit data, process received data, and/or control operation of the optical module 224. The communication device 222 may further include memory, input/output interfaces, and other supporting circuitry.

In some examples, the communication device 222 may include a host system, a switch, a router, a network interface controller (NIC), a data processing unit (DPU), an accelerator, or other electronic device configured to communicate with the optical module 224. In some examples, the communication device 222 may include or be coupled to serializer/deserializer (SerDes) circuitry configured to transmit and receive high-speed electrical signals over the electrical interface 234. The communication device 222 may further include protocol-layer circuitry, such as media access control (MAC) circuitry, configured to process data prior to transmission over the electrical interface 234 and after reception from the optical module 224.

The electrical interface 234 may include an interface between the communication device 222 and the optical module 224 for the transmission and reception of electrical signals. The electrical interface 234 may include one or more electrical connections, channels, or lanes that convey electrical signals between the communication device 222 and the optical module 224. In some examples, the electrical interface 234 may include one or more differential signal pairs, conductive traces, connectors, pads, contacts, or other interconnect structures that support signal transmission.

In some examples, the electrical interface 234 may support serialized data communication using one or more SerDes lanes. Each lane may carry data using signaling schemes such as non-return-to-zero (NRZ), pulse amplitude modulation (PAM), including PAM4, or other modulation formats. The electrical interface 234 may include multiple lanes that operate in parallel to support higher aggregate bandwidth.

In some examples, the electrical interface 234 may be implemented using a pluggable module interface or may be implemented using other types of electrical interconnects, including cable-based interfaces, board-to-board connectors, backplane interconnects, or integrated interconnect structures. The electrical interface 234 may support bidirectional communication, including one or more transmit paths and one or more receive paths, between the communication device 222 and the optical module 224.

In some examples, the communication device 222 may be configured to transmit data to the optical module 224 for optical transmission over the optical link 236, and to receive data from the optical module 224 that has been received via the optical link 236. The communication device 222 may operate in conjunction with the optical module 224 to support high-speed communication over one or more electrical and optical channels.

The optical module 224 may exchange electrical signals with the communication device 222 via the electrical interface 234 and may transmit and receive optical signals over the optical link 236. The optical module 224 may include circuitry and components that support signal transmission, signal reception, and signal processing across electrical and optical domains.

In the example illustrated in FIG. 2, the optical module 224 includes DSP circuitry 228 and FEC circuitry 132. The DSP circuitry 228 may perform signal processing operations on signals associated with the optical link 236 and the electrical interface 234, including, for example, equalization, filtering, signal conditioning, clock and data recovery, and other processing operations. The FEC circuitry 132 may perform forward error correction operations, including encoding, decoding, error detection, and error correction.

In some examples, the FEC circuitry 132 may be implemented as part of the DSP circuitry 228, and in other examples, the FEC circuitry 132 may be implemented as separate circuitry within the optical module 224. The DSP circuitry 228 and the FEC circuitry 132 may operate together to improve signal integrity and support reliable communication over the optical link 236.

In some examples, the optical module 224 may further include additional components, such as optical front-end circuitry, electrical interface circuitry, transmit circuitry, receive circuitry, and control circuitry. These components may support conversion between electrical and optical signals, as well as preparation and recovery of signals transmitted over the optical link 236.

In some examples, the optical module 224 may be implemented as a pluggable optical module, an integrated optical module, or another form of communication module. The optical module 224 may be used in conjunction with the communication device 222 to support high-speed communication over one or more optical channels.

The optical link 236 may include a communication medium that carries optical signals between the optical module 224 and the optical module 226 for the transmission of data. The optical link 236 may carry information using optical waveforms or optical symbols between devices and may support unidirectional or bidirectional communication. In some examples, the optical link 236 may include one or more optical channels or lanes, each carrying a corresponding optical signal.

In some examples, the optical link 236 may include one or more optical fibers, such as single-mode fibers (SMF), multi-mode fibers (MMF), or other optical waveguides. The optical link 236 may include additional optical components, such as connectors, couplers, splitters, multiplexers, demultiplexers, or other passive or active optical elements. In some examples, the optical link 236 may support wavelength-division multiplexing (WDM), coarse WDM (CWDM), dense WDM (DWDM), or other multiplexing techniques in which multiple optical wavelengths are transmitted over a shared medium.

In some examples, the optical link 236 may support high-speed optical communication using modulation formats such as non-return-to-zero (NRZ), pulse amplitude modulation (PAM), including PAM4, or coherent optical modulation formats. The optical link 236 may operate over short-reach, medium-reach, or long-reach distances, such as within a data center, between data centers, or across longer-haul communication networks.

In some examples, the components illustrated in FIG. 2 may be arranged differently, and additional or fewer components may be included. In some examples, one or more functions of the optical module 224 may be implemented in other devices or distributed across multiple components.

### Exemplary optical transceiver architecture with forward error correction circuitry

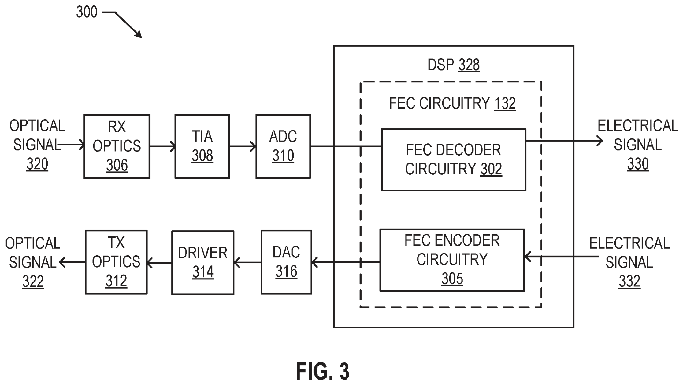

FIG. 3 illustrates an exemplary transceiver architecture 300 that includes optical front-end circuitry, data converter circuitry, and a digital signal processing block with forward error correction circuitry.

In the receive path, the transceiver architecture 300 may convert an incoming optical signal into a processed electrical output by passing the signal through an optical front end, an analog amplification stage, an analog-to-digital conversion stage, and digital processing circuitry. More specifically, an optical signal 320 may include a modulated optical carrier conveying data (e.g., via intensity, phase, and/or polarization modulation, and in some examples across one or more wavelengths and/or lanes) that may be received at the RX optics 306, which may convert the optical-domain input into an electrical-domain signal suitable for downstream receive processing. For example, the RX optics 306 may include one or more of a photodetector and/or associated optical coupling components (e.g., one or more of a lens or grating coupler, an optical filter, and a wavelength demultiplexer) to convert the received light into a photocurrent for downstream amplification. The resulting electrical signal may be provided to the transimpedance amplifier (TIA) 308 to amplify and condition the signal, and the conditioned signal may be digitized by the analog-to-digital converter (ADC) 310. The digitized samples may be provided to the DSP 328, which may include the FEC circuitry 132.

Within the FEC circuitry 132, the FEC decoder circuitry 302 may perform one or more forward error correction decoding operations (e.g., decoding, error detection, and/or error correction) on the received data to generate decoded data, corrected data, and/or error information, which may be output from the DSP 328 as an electrical signal 330 that may include a data stream (e.g., payload bits recovered from the optical signal 320). In some examples, the FEC decoder circuitry 302 may decode encoded data that was encoded with a folded turbo product code (fTPC) technique in which grouped-column component codewords are formed using groups of two or more columns. In some examples, the encoded data may lack parity-on-parity information.

In the transmit path, the transceiver architecture 300 may convert an incoming electrical input into an optical output by passing the signal through digital processing and forward error correction encoding circuitry, a digital-to-analog conversion stage, an analog driver stage, and an optical front end. More specifically, an electrical signal 332 may be received at the DSP 328, which may include the FEC circuitry 132. In some examples, the electrical signal 332 may include encoded data (e.g., data that has been encoded by a host device or other device in accordance with one or more encoding stages) and is provided to the transceiver architecture 300 for further processing and/or additional encoding.

Within the FEC circuitry 132, the FEC encoder circuitry 305 may perform one or more forward error correction encoding operations on the data to generate encoded data for transmission. In some examples, the FEC encoder circuitry 305 may encode the data in accordance with an fTPC technique in which the payload information is logically organized as a first number of columns and a second number of rows and grouped-column codewords are formed using groups of two or more columns to generate grouped-column parity information. In some examples, the FEC encoder circuitry 305 may omit parity-on-parity information (e.g., may exclude additional parity bits for protecting row parity information and/or grouped-column parity information) when generating the encoded data.

The encoded data may be provided to the digital-to-analog converter (DAC) 316 to generate an analog electrical waveform, which may be amplified and conditioned by the driver 314. The resulting analog electrical signal may be provided to the TX optics 312, which may convert the electrical-domain signal into an optical-domain output for transmission as an optical signal 322. For example, the TX optics 312 may include one or more of a light source (e.g., a laser diode or a continuous-wave laser coupled to an external modulator), an optical modulator, and associated optical coupling components (e.g., one or more of a grating coupler or edge coupler, an optical filter, and a wavelength multiplexer) to convert the driven electrical waveform into the optical signal 322 for transmission.

### Exemplary forward error correction circuitry

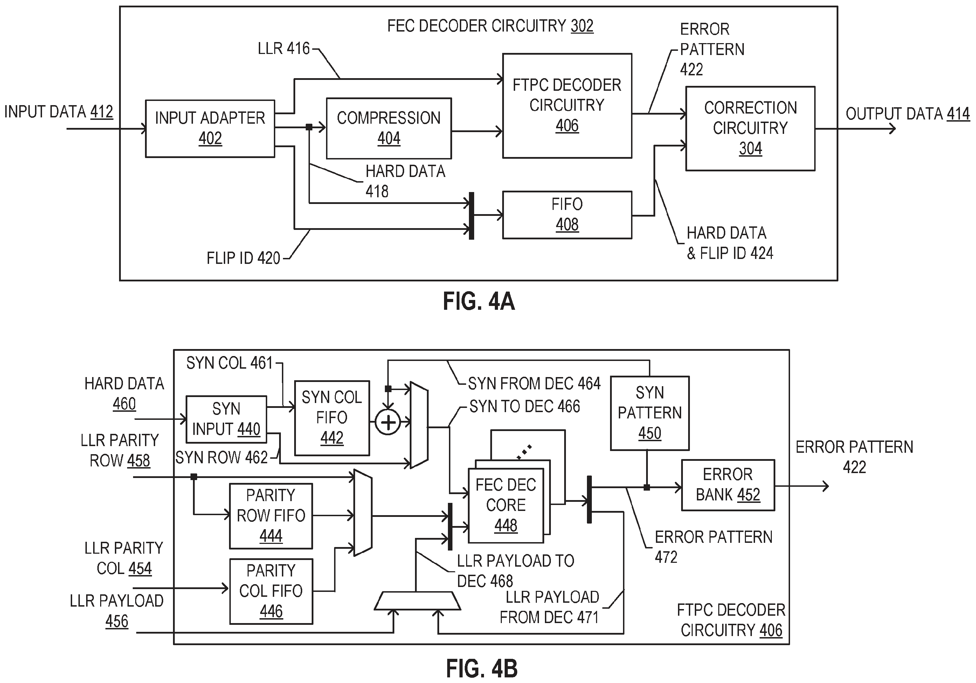

FIG. 4A illustrates an exemplary implementation of the FEC decoder circuitry 302 that may be used to decode encoded data and generate output data. As can be seen in FIG. 4A, the FEC decoder circuitry 302 receives input data 412 and provides output data 414. In the example illustrated in FIG. 4A, the FEC decoder circuitry 302 includes an input adapter 402, a compression block 404, fTPC decoder circuitry 406, a FIFO 408, and correction circuitry 304, which together support one or more decoding and correction operations.

The input data 412 may include encoded information received from upstream circuitry. For example, the input data 412 of FIG. 4A may be received from upstream processing circuitry, such as the DSP 328 (of FIG. 3) along the receive path, for example as data derived from digitized samples output by the ADC 310 and associated processing (e.g., equalization and/or demapping) prior to decoding by the FEC decoder circuitry 302. In some examples, the input data 412 may correspond to a received codeword that was previously encoded by an outer FEC code (e.g., a KP code) and by an inner FEC code (e.g., the fTPC), and the FEC decoder circuitry 302 may perform inner-code decoding and provide corrected information for subsequent processing and/or outer-code decoding.

The input data 412 may include payload information and parity information, and in some examples may be accompanied by soft information (e.g., reliability information) or may include information from which such soft information is derived. Payload information refers to data (which may include, e.g., user data or other primary data content) that is conveyed for delivery, storage, or processing. Payload information may include, for example, data bits associated with a communication protocol, packet payloads, frame contents, or other application-layer or protocol-layer information. Parity information refers to redundancy generated from payload information for purposes of error detection and/or error correction. Parity information may include, for example, parity bits, check bits, or other redundant values associated with one or more component codewords. In some examples, parity information includes row parity information and grouped-column parity information generated for respective row-related and column-related component codes. In various examples, parity information may exclude parity computed for other parity information (e.g., parity-on-parity). In some examples, the input data 412 may include metadata. In some examples, associated metadata may include one or more indicators that support decoding or post-processing, such as a flip identifier, block or lane identifiers, framing information, mode indicators, and/or other control information. In some examples, the payload information and parity information may be arranged into a two-dimensional turbo product code (TPC) block for row-related and column-related component-code operations.

### Exemplary turbo product code blocks

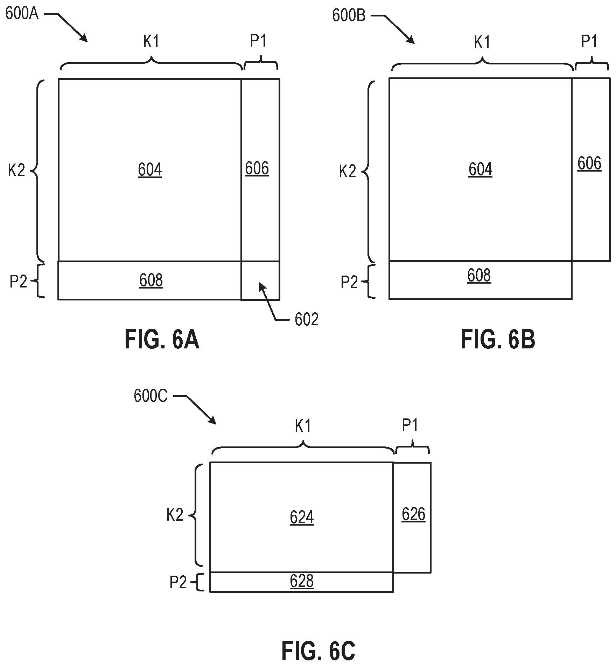

For example, FIGS. 6A-6C illustrate exemplary bit arrangements for product-code-based forward error correction in which payload information and parity information are organized into a two-dimensional block structure to support row-related and column-related component-code operations. In some examples, the payload information and parity information described above (e.g., within the input data 412) may include block bits (or values derived from block bits) used in one or more encoding, decoding, and/or iterative processing operations. FIG. 6A illustrates a conventional turbo product code (TPC) block that includes parity-on-parity (checks-on-checks). FIG. 6B depicts a TPC block in which parity-on-parity is omitted. FIG. 6C depicts a folded TPC block in which parity-on-parity is omitted.

Referring to FIG. 6A, a conventional TPC block 600A may include a payload 604 having K2 rows and K1 columns, where the payload 604 stores payload bits (e.g., data bits) arranged in a two-dimensional array. In some examples, row parity information 606 may be generated for row-related component codewords, for example by encoding each of the K2 rows of the payload 604, and the row parity information 606 may be arranged as one or more parity columns adjacent to the payload 604 (e.g., one or more parity columns after the K1 payload columns). In some examples, column-related parity 608 may be generated for column-related component codewords, for example by encoding each of the K1 columns of the payload 604 and, in some examples, one or more associated parity columns. The column-related parity 608 may be arranged as one or more parity rows adjacent to the payload 604 (e.g., one or more parity rows after the K2 payload rows). In the example of FIG. 6A, the TPC block 600A also includes a parity-on-parity region 602 (also referred to as checks-on-checks), which may include parity bits generated for parity bits, for example parity computed for at least a subset of the row parity information 606 and/or the column-related parity 608, which may provide additional protection for parity information.

FIG. 6B illustrates another example of a TPC block 600B that includes a payload 604 having K2 rows and K1 columns. As described above with reference to FIG. 6A, row parity information 606 may be generated for row-related component codewords and arranged as one or more parity columns adjacent to the payload 604, and column-related parity 608 may be generated for column-related component codewords and arranged as one or more parity rows adjacent to the payload 604.

In the example of FIG. 6B, parity-on-parity (checks-on-checks) is omitted, such that a parity-on-parity region (e.g., the parity-on-parity region 602 of FIG. 6A) may be absent. For example, the parity information of the TPC block 600B may exclude additional parity bits for protecting the row parity information 606 and/or the column-related parity 608. For example, the column-related parity 608 may be generated based on payload columns (e.g., the K1 columns of the payload 604) without additionally generating column-related parity for the row parity information 606, and/or the row parity information 606 may be generated based on payload rows (e.g., the K2 rows of the payload 604) without additionally generating row-related parity for the column-related parity 608, such that parity bits may be associated with a single component codeword rather than being protected by both row-related and column-related component codes.

In some examples, omitting parity-on-parity may reduce error-correction performance relative to a TPC block that includes checks-on-checks, for example by reducing protection for parity information and/or introducing an increased likelihood of residual errors (e.g., an elevated error floor under some conditions). However, in some examples, such performance tradeoffs may be acceptable, for example where the TPC block 600B is used as an inner code in a concatenated coding architecture and an outer code is used to correct at least a portion of residual errors that remain after decoding of the TPC block 600B.

FIG. 6C illustrates an example of a folded TPC block 600C in which payload information and parity information are arranged to support row-related and grouped-column-related component-code operations while omitting parity-on-parity (checks-on-checks). In the example shown, the folded TPC block 600C includes a payload 624 that is logically organized as a first number of columns and a second number of rows (e.g., K1 columns and K2 rows), where the first number is greater than the second number (e.g., K1 > K2). The logical organization of the payload information as rows and columns may be for the purposes of performing one or more encoding and/or decoding operations (e.g., defining row-related and grouped-column-related component codewords); such a logical organization does not necessarily imply that the payload 624 is transmitted, buffered, or stored as an explicit two-dimensional matrix; rather, the payload 624 may be conveyed and/or stored in any suitable format (e.g., a serial stream, a parallel bus, or a linear memory layout) and may be mapped to the logical rows and columns for component-code processing.

As described above with reference to FIG. 6A, row-related parity information may be generated for row-related component codewords and arranged as one or more parity columns adjacent to the payload 624 (e.g., the row parity information 626). However, unlike in the TPC blocks 600A and 600B of FIGS. 6A-6B, where column parity information is determined for each column, FIG. 6C illustrates a folded TPC block in which parity information is for a group of columns rather than for a single column. For example, grouped-column parity information 628 includes parity bits for the data bits from two or more of the K1 columns of the payload 624. Accordingly, a grouped-column-related codeword includes bits from multiple columns of the payload 624 (e.g., bits from the columns in the group across the K2 rows). In various examples, a group of columns may have g columns, where g is an integer greater than 1 and smaller than or equal to half of the K1 (i.e., smaller than or equal to half the number of columns). In some examples, an individual row of the payload 624 may have the same number of bits as the group of columns (e.g., the same number of bits as in g columns), such that a row codeword and a grouped-column codeword may be encoded and decoded in accordance with the same component code.

In some implementations, one or more of the component codes may be block codes such as BCH codes, Hamming codes, extended Hamming codes, Reed-Solomon codes (e.g., symbol-based codes), or other linear block codes that may support bounded-distance decoding and/or soft-assisted decoding. In one example, the row-related component codewords and the grouped-column-related component codewords are each based on an extended Hamming code. In some examples, use of the same component code for row-related and grouped-column-related decoding may simplify decoder implementation, memory organization, and reuse of decoding resources. In some examples, the row-related component codewords and the grouped-column-related component codewords may be encoded and/or decoded in accordance with different component codes. For example, a row-related component code may be a first component code and a grouped-column-related component code may be a second component code different from the first component code. In some examples, the first component code and the second component code may differ in one or more of code type, code length, number of parity bits, and/or error-correction capability. In some examples, use of different component codes for row-related and grouped-column-related operations may allow error-correction characteristics to be independently selected for each dimension, for example to accommodate differences in error statistics, codeword length, and/or implementation constraints associated with the row-related and grouped-column-related codewords.

Thus, the parity information for the folded TPC block 600C includes row parity information 626 for an individual row and grouped-column parity information 628 for a group of two or more columns. In some examples, by folding the block such that the number of rows is smaller than the number of columns, the folded TPC block 600C may reduce buffering and/or latency relative to an unfolded TPC block, for example by enabling decoding of grouped-column-related codewords to start after receipt of payload information for the second number of rows rather than after receipt of payload information for a larger, unfolded block. Additionally, as with FIG. 6B, parity-on-parity information may be omitted such that the folded TPC block 600C may exclude additional parity bits for protecting the row parity information 626 and/or the grouped-column parity information 628. As mentioned briefly above, omitting parity-on-parity information may reduce the total amount of parity information to be generated, transmitted, buffered, and/or processed, which may reduce overhead and may further reduce latency and/or implementation cost (e.g., memory, area, and/or power) relative to a TPC block that includes parity-on-parity.

In some examples, the columns in a group may be consecutive columns or non-consecutive columns. For a group with non-consecutive columns, at least two columns in the group are separated by one or more intervening columns. In one example, non-consecutive columns may be selected according to a stride greater than one, which may have the benefit of distributing channel impairments across component codewords.

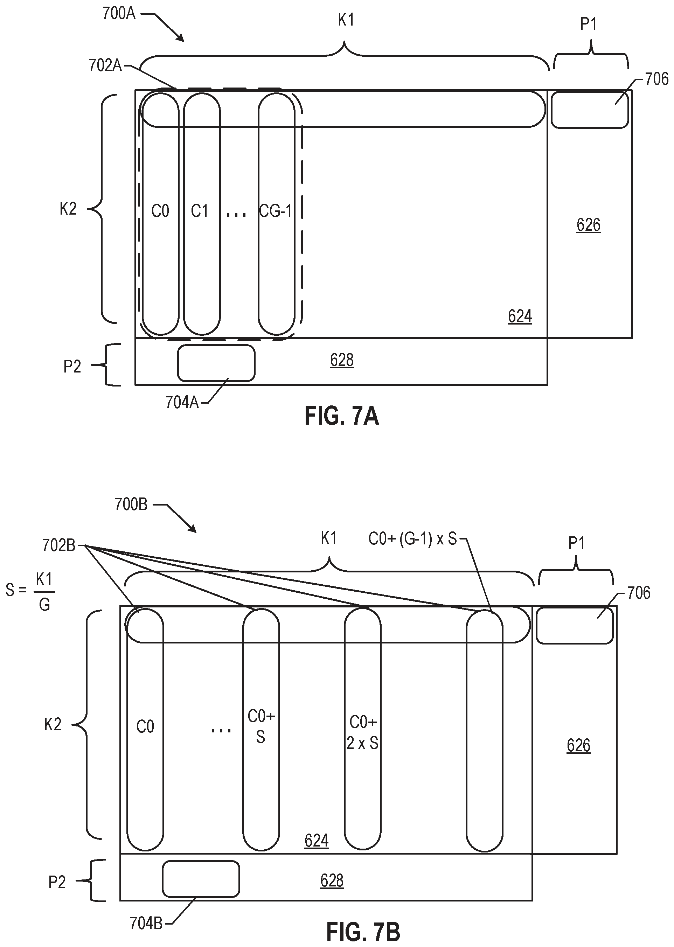

For example, FIG. 7A illustrates an example of a folded TPC block 700A where a group includes consecutive columns. As can be seen in FIG. 7A, the group 702A may include adjacent columns within the payload 624 (e.g., consecutive columns labeled C0, C1, ..., CG-1), and bits from those consecutive columns (e.g., across the K2 rows) may be treated as a grouped-column codeword for purposes of generating and/or using grouped-column parity. The parity information 704A may represent parity information for the group 702A (e.g., grouped-column parity for the codeword formed from the columns in the group 702A) and may be included within a grouped-column parity region (e.g., within grouped-column parity information 628). FIG. 7A also illustrates row-related parity in which the parity information 706 may represent parity information for a row (e.g., row parity for a corresponding row of the payload 624) and may be included within a row parity region (e.g., within the row parity information 626). In one example, the number of parity bits for an individual row may be equal to the number of parity bits for a group of columns (e.g., the number of parity bits in the parity information 704A may be equal to the number of parity bits in the parity information 706).

FIG. 7B illustrates an example of a folded TPC block 700B where a group includes non-consecutive columns. As can be seen in FIG. 7B, the group 702B includes columns that are separated by one or more intervening columns within the payload 624. In one example, the non-consecutive columns in the group 702B may be selected according to a stride S across the K1 columns, such that the group 702B includes columns that may include, for example, columns labeled C0, C0+S, C0+2×S, ..., C0+(G-1)×S. In one example, the stride S may correspond to the number of columns K1 divided by the number of columns in a group G (e.g., S = K1/G), although other stride values and/or selection patterns may be used. Bits from the non-consecutive columns (e.g., across the K2 rows) may be treated as a grouped-column codeword for purposes of generating and/or using grouped-column parity. The parity 704B may represent parity information for the group 702B (e.g., grouped-column parity for the codeword formed from the columns in the group 702B) and may be included within a grouped-column parity region (e.g., within the grouped-column parity information 628). FIG. 7B also illustrates row-related parity in which the parity information 706 may represent parity information for a row (e.g., row parity for an individual row of the payload 624) and may be included within a row parity region (e.g., within the row parity information 626).

In some examples, the payload information may be interleaved prior to generation of one or more grouped-column codewords and/or prior to one or more row-related encoding or decoding operations. For example, the payload information may be interleaved according to an N-way interleaving pattern before grouped-column-related component-code processing and may be de-interleaved after one or more decoding operations. In some examples, interleaving may reduce dependency among error events and may distribute error-affected bits across multiple component codewords, which may improve error-correction effectiveness for bounded-distance decoding and/or iterative decoding. In some examples, the interleaving pattern may be selected such that bits that are adjacent in a transmitted stream are mapped to different row-related and/or grouped-column-related component codewords.

Accordingly, referring again to FIG. 4A, the input data 412 may include encoded data that was encoded in accordance with a folded error-correction code. In some examples, the folded error-correction code may omit parity-on-parity (checks-on-checks), such that the input data 412 may exclude additional parity bits for protecting parity information (e.g., the row-related parity information and/or grouped-column-related parity information).

The input data 412 may be provided in any suitable form, such as a serial stream, a parallel bus, lane-based data, framed blocks, or packets, and may be accompanied by one or more clocking, control, or status signals to support synchronization and interface operation. The input adapter 402 may include and/or be coupled to I/O circuitry to receive the input data 412 and may perform one or more interface and conditioning operations to prepare the input data 412 for downstream processing by the compression block 404 and the fTPC decoder circuitry 406. For example, the input adapter 402 may perform one or more of lane alignment, de-serialization, framing or block delineation, buffering, reformatting, and ordering of samples or bits, and may generate and/or extract associated information such as reliability information (e.g., the LLR 416) and metadata (e.g., the flip ID 420) and hard data 418. Hard data 418 may include a hard-decision representation of received information, such as bit values (e.g., 0/1 decisions) and/or symbol decisions generated from slicing and/or demapping and/or other receive processing.

In some examples, the hard data 418 may include hard decisions for one or more encoded bits (e.g., payload and/or parity bits). LLR 416 may include log-likelihood ratio information (or other reliability metrics) associated with received symbols or bits, and may indicate a confidence level for a corresponding hard decision for use by downstream decoding operations. In some examples, the LLR 416 may include a signed value that conveys both a polarity (e.g., indicating a more likely bit value) and a magnitude (e.g., indicating confidence). In one example, the LLR 416 may be provided as an absolute-value LLR, which may represent a magnitude of reliability.

In some examples, the input adapter 402 may buffer and/or assemble a product-code block that has fewer rows (and/or fewer bits) than an unfolded product-code block. For example, folding may enable decoding to begin after fewer rows (or fewer bits) have been collected, which may reduce buffering and/or latency. For example, the folded product-code arrangements described with reference to FIGS. 6C, 7A, and 7B may allow grouped-column codewords to be formed using a group of columns while using a smaller number of rows than a conventional TPC arrangement (e.g., such as shown in FIG. 6A).

In some implementations, readiness to start decoding may be determined using one or more counters, valid flags, lane-alignment indicators, block-completion indicators for a set of logical rows, and/or address mapping information that associates received payload bits with positions of the folded product-code arrangement. For example, after payload bits for the second number of rows have been stored for a given group of two or more columns, the decoder circuitry may read out the corresponding bits as a grouped-column codeword, obtain associated parity information and reliability information, and initiate one or more grouped-column decoding operations. In some examples, this approach allows decoding resources to be activated earlier in time than in a conventional arrangement in which a larger block would first be collected before decoding begins.

Consider a conventional TPC block, such as shown in FIG. 6A, where K1 = 16 columns and K2 = 16 rows, such that a receiver may buffer 256 payload bits (16×16) before operating on a full block. In contrast, consider a folded TPC example, such as shown in FIG. 6C, where the payload may be logically organized with K1 = 16 columns and K2 = 4 rows (so that K1 is greater than K2). In one such example, the input adapter 402 may buffer 64 payload bits (4×16) before starting decoding. In one such example, a group size G of 4 columns may be used so that a grouped-column codeword includes bits from 4 columns across the 4 rows (yielding 16 bits, matching an individual row length). In some examples, buffering fewer payload bits before starting decoding may reduce buffer memory and associated data-movement, which may reduce implementation area and/or power and may also reduce end-to-end latency.

The compression block 404 may receive information from the input adapter 402 and may generate one or more representations of the received information for decoding by the fTPC decoder circuitry 406. For example, the compression block 404 may apply a mapping or compression operation (e.g., based on a compression matrix) to transform a received multi-bit symbol representation into a reduced-bit representation for use by decoding circuitry (e.g., the fTPC decoder circuitry 406), such as by combining two or more bit positions to generate one or more compressed bits. In some examples, the input adapter 402 may also output a flip ID 420 associated with the compressed bits, where the flip ID 420 may indicate how a decoding decision in the compressed domain maps back to one or more underlying bit positions of the received multi-bit symbol representation. For example, when the fTPC decoder circuitry 406 indicates that a particular compressed bit is to be flipped or corrected, the flip ID 420 may identify which corresponding bit position of the underlying multi-bit symbol representation is to be flipped when applying the correction. The compression block 404 may output the compressed representation to the fTPC decoder circuitry 406.

In the example illustrated in FIG. 4A, the fTPC decoder circuitry 406 receives a compressed representation output by the compression block 404 and associated reliability information such as the LLR 416 and performs one or more decoding operations for a folded error-correction code (e.g., a folded turbo product code) to generate error correction information. In some examples, the fTPC decoder circuitry 406 may perform iterative decoding that includes processing row-related codewords and grouped-column-related codewords over one or more iterations, as explained in more detail below. In some examples, the fTPC decoder circuitry 406 may perform component-code decoding (e.g., using Chase decoding or another decoding technique) based on hard decisions and associated reliability information, and may selectively perform decoding operations based on one or more error indications (e.g., syndrome checks) and/or magnitudes of reliability values.

In some examples, iterative processing may be performed over syndrome information and reliability information, such as magnitudes of LLR values associated with payload bits and/or parity bits, rather than by repeatedly reconstructing complete corrected codewords at each internal stage. For example, syndrome-related information may be updated across iterations based on one or more decoding outcomes, and payload-related reliability information may be selectively reused, updated, or combined for a subsequent iteration. In some examples, this iterative approach may allow the decoder to capture coding gain while limiting implementation cost associated with excessive buffering, sorting, or message-passing complexity.

The fTPC decoder circuitry 406 may output an error pattern 422 that identifies one or more corrections to be applied to the compressed data, and the error pattern 422 may be provided to the correction circuitry 304 for generation of the output data 414. An error pattern may refer to information that identifies one or more bit locations and/or corresponding correction indications produced by decoder circuitry for use in correcting received information. In some examples, the error pattern may indicate which payload-bit positions, compressed-bit positions, codeword-bit positions, symbol-bit positions, or other bit representations are to be flipped, corrected, or otherwise modified. In some examples, the error pattern may include a bitmap, a list of bit indices, one or more flip decisions, one or more correction vectors, or other information sufficient to identify a set of corrections to be applied to received hard data and/or to an associated representation of the received information.

The FIFO 408 may store and/or time-align information for use by the correction circuitry 304. For example, the FIFO 408 may receive the hard data 418 and the flip ID 420 and may buffer the hard data 418 and the flip ID 420 to account for processing latency through the fTPC decoder circuitry 406. The FIFO 408 may output the hard data and flip ID 424 to the correction circuitry 304 so that the correction circuitry 304 may apply one or more corrections indicated by the error pattern 422 with reference to the corresponding hard-decision information and associated flip identification information.

In the example illustrated in FIG. 4A, the correction circuitry 304 generates the output data 414 based on correction information produced by the fTPC decoder circuitry 406. For example, the correction circuitry 304 receives the error pattern 422 from the fTPC decoder circuitry 406 and hard data and flip IDs 424 from the FIFO 408 and applies one or more corrections to the hard data based on the error pattern 422 and the flip IDs to generate corrected data. In some examples, the correction circuitry 304 may use the flip ID 424 to map a correction decision associated with a compressed-bit position to a corresponding bit position of an underlying representation of the received information (e.g., a multi-bit symbol representation), such as by selecting a bit to flip when applying a correction indicated by the error pattern 422. The correction circuitry 304 outputs the corrected data, and/or associated status or error information, as the output data 414 (e.g., corrected payload information and/or associated indicators).

### Exemplary fTPC decoder circuitry

FIG. 4B illustrates an exemplary implementation of the fTPC decoder circuitry 406 introduced in FIG. 4A. In the example illustrated in FIG. 4B, the fTPC decoder circuitry 406 receives the hard data 460, LLR information for the payload (e.g., LLR payload 456), LLR information for the parity column (LLR parity col 454), and LLR information for the parity row (LLR parity row 458), decodes the encoded data, and outputs an error pattern 422 for use by the correction circuitry 304.

In some examples, the fTPC decoder circuitry 406 may generate and/or process syndrome information associated with one or more component codewords based on the hard data 460. For example, the fTPC decoder circuitry 406 includes syndrome input circuitry 440 to receive the hard data 460 (or information derived from the hard data 460) and generate syndrome column information 461 and syndrome row information 462, which may represent syndrome information for column-related and row-related codewords, respectively. In some examples, the syndrome column information may correspond to grouped-column component codewords formed by grouping bits associated with multiple columns, such as the grouped-column arrangements described with reference to FIGS. 6C, 7A, and 7B. In some examples, the syndrome row information may correspond to row component codewords, such as component codewords associated with respective rows of the payload as described with reference to FIG. 6C. In some examples, the syndrome information may indicate whether a candidate codeword includes one or more errors and may be used to control subsequent decoding operations (e.g., whether to invoke one or more decoding steps for a given codeword). As one example, the syndrome information may include a set of syndrome bits and/or a syndrome value that is a first value (e.g., zero) when a corresponding codeword is error-free and a second value (e.g., non-zero) when one or more errors are present.

The fTPC decoder circuitry 406 may include one or more buffering structures and/or alignment structures to support time alignment and one or more decoding operations (e.g., iterative processing) of syndrome information and reliability information. In the example illustrated in FIG. 4B, the fTPC decoder circuitry 406 includes a syndrome column FIFO 442 to buffer the syndrome column information 461 to align syndrome information with decoding operations. In the example illustrated in FIG. 4B, the fTPC decoder circuitry 406 also includes a parity row FIFO 444 and the parity col FIFO 446 to buffer parity-related reliability information, such as the LLR parity row 458 and the LLR parity col 454, to accommodate processing latency and/or to provide the parity-related reliability information at one or more times during decoding and/or across one or more iterations (e.g., for reuse and/or scheduling of the parity-related reliability information during decoding). In some examples, where checks-on-checks (e.g., parity-on-parity) are omitted, parity bits may participate in a single component codeword. In such examples, the parity-related reliability information (e.g., the LLR parity row 458 and/or the LLR parity col 454) may be buffered and reused across iterations. For example, extrinsic updating may be applied to payload-bit reliability information exchanged between row-related and grouped-column-related decoding, while parity-bit reliability information may be reused (e.g., extrinsic updating may be performed for payload bits but not for parity bits). In one such example, this may reduce decoder complexity and data movement (e.g., fewer LLR update operations and/or less buffering bandwidth), which may reduce power and/or latency.

In the example illustrated in FIG. 4B, the fTPC decoder circuitry 406 includes selection and/or combining circuitry (e.g., a multiplexer) to provide syndrome-related information to the FEC decoder core 448 and to support one or more decoding operations, including, in some examples, iterative processing. For example, the fTPC decoder circuitry 406 may select between syndrome information generated by the syndrome input circuitry 440 (e.g., the syndrome column information 461 and/or the syndrome row information 462, including buffered versions) and syndrome-related information output by the FEC decoder core 448 (e.g., the syndrome information 464), and may provide a selected and/or combined syndrome as the syndrome information (e.g., the syndrome information 466) provided to the FEC decoder core 448. In some examples, the selection and/or combining circuitry may route the syndrome information output from the FEC decoder core 448 during a previous iteration to the FEC decoder core 448 for the next iteration.

In some examples, the fTPC decoder circuitry 406 also includes selection and/or combining circuitry (e.g., a multiplexer) to provide payload-related reliability information to the FEC decoder core 448 for one or more decoding operations and, in some examples, for iterative processing. For example, the selection and/or combining circuitry may receive an initial payload reliability input (e.g., the LLR payload 456) and updated payload reliability information output by the FEC decoder core 448 (e.g., the LLR payload from DEC 471), and may output selected and/or combined payload reliability information as the LLR payload to DEC 468 for use by the FEC decoder core 448. In some examples, the selection and/or combining circuitry may route the updated payload reliability information from a previous iteration as an input to the FEC decoder core 448 for a subsequent iteration.

The FEC decoder core 448 may perform one or more decoding operations based on syndrome information and reliability information. For example, the FEC decoder core 448 may receive the syndrome information 466 and reliability information and process the reliability information in view of the syndrome information to generate updated reliability information and/or other decoding outputs, such as updated LLR information for the payload (e.g., LLR payload from decoder 471) and an error pattern 472. In some examples, the fTPC decoder circuitry 406 may include multiple instances of the FEC decoder core 448 to support parallel and/or pipelined decoding, such as by operating on different codewords, blocks, or iterations concurrently. In the example illustrated in FIG. 4B, the updated reliability information may be used for a subsequent decoding iteration with the FEC decoder core 448.

The fTPC decoder circuitry 406 may generate correction-related information for use in subsequent iterations. For example, the syndrome pattern circuitry 450 receives the error pattern 472 and outputs syndrome information (e.g., syndrome information 464) for the error pattern 472. The syndrome information from the decoder may be used for a subsequent decoding iteration. In some implementations, the error bank 452 may accumulate and/or combine error indications across one or more decoding operations and/or iterations.

In some examples, the error bank 452 may output the correction information as the error pattern 422. The error pattern 422 may identify one or more bit positions to be corrected and may be provided to the correction circuitry 304 to support generation of corrected output data.

In some implementations, one or more blocks of FIG. 4B may be combined, reordered, replicated for parallelism, or otherwise modified based on throughput, latency, and implementation targets. In addition, the fTPC decoder circuitry 406 may support one or more iteration controls, termination criteria, and/or modes of operation.

### Exemplary forward error correction decoder core

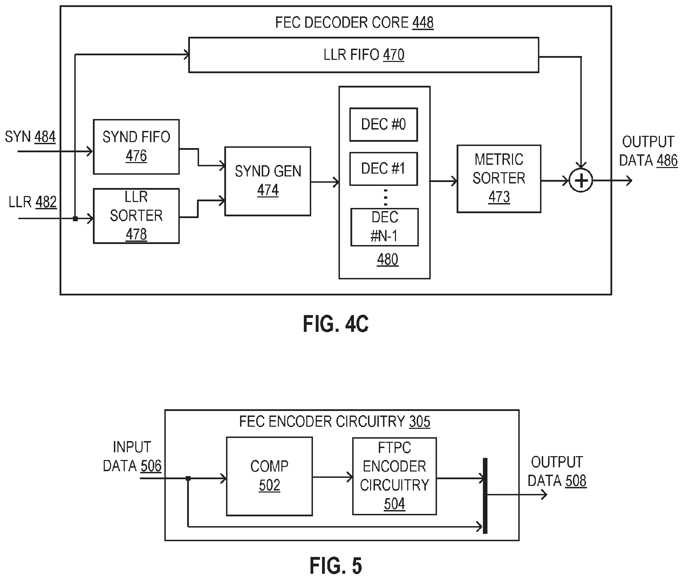

FIG. 4C illustrates an example of the FEC decoder core 448 of FIG. 4B, showing how syndrome information and reliability information may be processed to produce a decoding output. In the example of FIG. 4C, syndrome information (SYN 484), which may correspond to syndrome information provided to the FEC decoder core 448 in FIG. 4B, is buffered by the syndrome FIFO 476 and provided to syndrome generation circuitry 474. Reliability information (LLR 482), which may correspond to at least a portion of the reliability information provided to the FEC decoder core 448 in FIG. 4B, may be provided to an LLR sorter 478 and also buffered by an LLR FIFO 470 (e.g., for time alignment). The syndrome generation circuitry 474 may use the buffered syndrome information and the reliability information (e.g., sorted LLR information) to control one or more component-code decoding operations performed by decoders 480 (e.g., a set of decoder instances DEC #0 through DEC #N-1), which may operate in parallel to process one or more candidate decoding cases for a component codeword.

The decoder outputs may be evaluated by a metric sorter 473 (e.g., to select one or more preferred candidates based on one or more decoding metrics), and a combining operation may combine and/or incorporate the decoder-derived output from the metric sorter 473 with buffered reliability information from the LLR FIFO 470 to generate output data 486. In some examples, the output data 486 may include updated reliability information (e.g., updated LLR information for one or more bits).

### Exemplary encoder circuitry

FIG. 5 illustrates an example of the FEC encoder circuitry 305 that may be used to encode data in accordance with a folded error-correction code. In the example shown, the FEC encoder circuitry 305 includes a compression block 502 and the fTPC encoder circuitry 504 arranged in a transmit path from the input data 506 to the output data 508. In some examples, the FEC encoder circuitry 305 may include and/or be coupled to input/output (I/O) circuitry to receive payload information (e.g., within the input data 506), and the fTPC encoder circuitry 504 may logically organize the payload information as a first number of columns and a second number of rows, where the first number is greater than the second number, generate row parity information for a row of the second number of rows, and generate grouped-column parity information for a group of two or more of the columns of the first number of columns. In some examples, the output data 508 may include encoded data that includes the payload information and parity information, where the parity information includes the row parity information and the grouped-column parity information, for example, for subsequent transmission and/or storage and later decoding (e.g., by the FEC decoder circuitry 302 of FIG. 4A and the fTPC decoder circuitry 406 of FIG. 4B). In some examples, the fTPC encoder circuitry 504 may omit generating parity-on-parity information (e.g., omit generating additional parity bits for protecting the row parity information and/or the grouped-column parity information), and/or may begin generating the grouped-column parity information in response to receipt of payload information for the second number of rows.

### Exemplary method for decoding encoded data encoded in accordance with a folded error-correction code

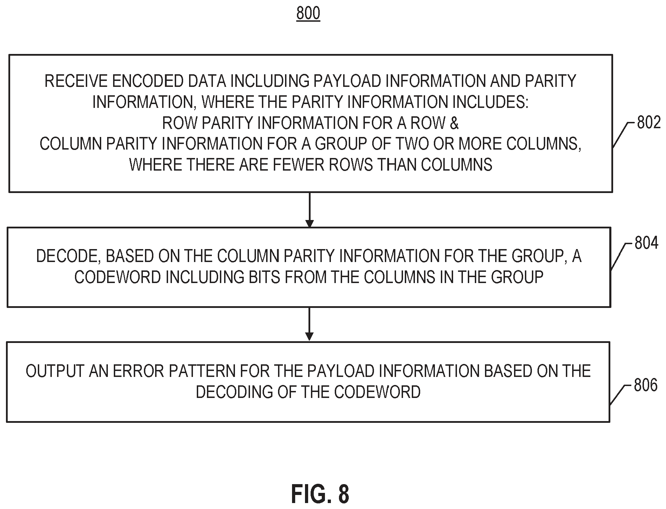

FIG. 8 depicts a flow chart illustrating a method 800 of decoding encoded data encoded in accordance with a folded error-correction code. The method 800 may be performed by decoder circuitry, such as the decoder circuitry 302 of FIG. 3 and FIG. 4A.

In 802, the method 800 includes receiving encoded data including payload information and parity information, where the parity information includes row parity information for a row and column parity information for a group of two or more columns, and where there are fewer rows than columns. For example, the encoded data may be received as the input data 412 of FIG. 4A, such as along a receive path after upstream processing and prior to decoding by the decoder circuitry. In one example, the encoded data may include a folded TPC block, such as described with reference to FIG. 6C; the received encoded data may correspond to bits of a folded product-code block in which the payload is logically organized as K1 columns and K2 rows (with K1 greater than K2), and the parity information includes (i) row parity information (e.g., parity bits for row component codewords) and (ii) grouped-column parity information for a group of two or more columns (e.g., parity bits for a grouped-column component codeword formed from bits associated with multiple columns across the K2 rows).

In 804, the method 800 includes decoding, based on the column parity information for the group, a codeword including bits from the columns in the group. For example, the decoding may be performed by decoder circuitry, such as the decoder circuitry 302 of FIG. 4A. In one example, the decoder circuitry 302 may decode a grouped-column component codeword using grouped-column parity information (e.g., column parity information) corresponding to a group of two or more columns, such as in the folded TPC arrangement described with reference to FIG. 6C. In some examples, the codeword may include bits associated with the columns in the group across a number of rows of a folded product-code block (e.g., across K2 rows), and the decoding may include performing a component-code decoding operation for the grouped-column-related component codeword based on the grouped-column parity information for the group. In some examples, the decoding may be performed using hard decisions and associated reliability information derived from the received encoded data (e.g., the input data 412 of FIG. 4A), for example, as part of an iterative decoding process.

In 806, the method 800 includes outputting an error pattern for the payload information based on the decoding of the codeword. For example, the decoder circuitry 302 of FIG. 4A (e.g., the fTPC decoder circuitry 406) may output an error pattern (e.g., the error pattern 422) that identifies one or more bit positions of the payload information to be corrected. In some examples, the error pattern may be generated based on decoding results for one or more grouped-column-related component codewords and/or row-related component codewords, and may indicate one or more flip decisions and/or correction indications for payload bits. In some examples, the method 800 includes correcting the payload data with correction circuitry (e.g., the correction circuitry 304 of FIG. 4A) based on the error pattern.

### Exemplary method for encoding payload information in accordance with a folded error-correction code

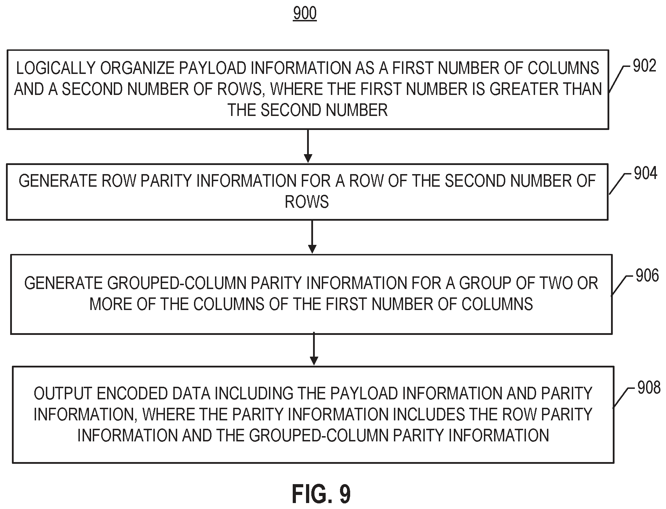

FIG. 9 depicts a flow chart illustrating a method 900 of encoding payload information in accordance with a folded error-correction code. The method 900 may be performed by encoder circuitry, such as the encoder circuitry 305 of FIG. 3 and FIG. 5.

In 902, the method 900 includes logically organizing the payload information as a first number of columns and a second number of rows, where the first number is greater than the second number. For example, the payload information may be received by encoder circuitry, such as the FEC encoder circuitry 305 of FIG. 5 (e.g., as the input data 506), and may be provided to the fTPC encoder circuitry 504 for encoding in accordance with a folded error-correction code. More specifically, the fTPC encoder circuitry 504 may map the payload information to a folded product-code block arrangement having K1 columns and K2 rows, where K1 is greater than K2, to support row-related and grouped-column-related component codewords. In some examples, logically organizing the payload information as rows and columns involves defining a mapping between positions in the payload information and a set of logical row indices and logical column indices for component-code processing. In some examples, this logical organization does not necessarily involve transmitting, buffering, or storing the payload information as an explicit two-dimensional matrix; rather, the payload information may be conveyed and/or stored in any suitable format and mapped to the logical rows and columns for component-code processing.

In 904, the method 900 includes generating row parity information for a row of the second number of rows. For example, generating the row parity information may be performed by encoder circuitry, such as the FEC encoder circuitry 305 of FIG. 5 (e.g., the fTPC encoder circuitry 504). In some examples, generating the row parity information includes encoding bits of an individual row of the payload information in accordance with a component code to produce one or more row parity bits for that row. In one example, such as shown in FIG. 6C, the row parity information may correspond to parity bits arranged as one or more parity columns (e.g., the row parity information 626) that are associated with respective rows of the payload. In some examples, generating the row parity information may be performed on a row-by-row basis as payload bits for the row are received and/or mapped to the row, and the row parity information may be included in parity information output with the payload information as encoded data.

In 906, the method 900 includes generating grouped-column parity information for a group of two or more of the columns of the first number of columns. For example, generating the grouped-column parity information may be performed by encoder circuitry, such as the FEC encoder circuitry 305 of FIG. 5 (e.g., the fTPC encoder circuitry 504). In some examples, generating the grouped-column parity information includes forming a grouped-column codeword that includes bits from the columns in the group and encoding the grouped-column codeword in accordance with a component code to produce one or more grouped-column parity bits for the group. In one example, such as shown in FIG. 6C, the grouped-column parity information may correspond to parity bits arranged as one or more parity rows (e.g., the grouped-column parity information 628) that are associated with respective groups of columns of the payload. In some examples, the group may include consecutive columns or non-consecutive columns, such as illustrated by FIGS. 7A and 7B. In some examples, generating the grouped-column parity information may be performed on a group-by-group basis in response to receipt of payload information for the second number of rows and/or as payload bits are mapped to the group, and the grouped-column parity information may be included in parity information output with the payload information as encoded data.

In 908, the method 900 includes outputting encoded data including the payload information and parity information, where the parity information includes the row parity information and the grouped-column parity information. For example, the FEC encoder circuitry 305 of FIG. 5 (e.g., the fTPC encoder circuitry 504) may provide the encoded data as output data (e.g., the output data 508) for subsequent transmission and/or storage. In some examples, the encoded data may be output in any suitable form, such as a serial stream, a parallel bus, lane-based data, framed blocks, or packets, and may be accompanied by one or more clocking, control, or status signals to support synchronization and interface operation. In one example, the encoded data may correspond to a folded product-code block arrangement in which the payload information is output together with parity information that includes row parity information (e.g., parity bits associated with respective rows) and grouped-column parity information (e.g., parity bits associated with respective groups of two or more columns), such that the encoded data provides both row-related and grouped-column-related parity protection for the payload information. In some examples, the parity information may exclude parity-on-parity information, such that the encoded data may omit additional parity bits for protecting the row parity information and/or the grouped-column parity information.

Accordingly, folded forward error-correction codes such as those described herein may enable a reduction in buffering and decoder latency by allowing decoding and/or encoding to start after receiving and/or assembling fewer bits than would be used for a conventional product-code block. In some examples, the folding may be achieved by forming grouped-column component codewords from bits associated with a group of two or more columns, which may reduce an amount of data buffered for a block and associated storage requirements while maintaining component-code structure for row-related and grouped-column-related processing. In some examples, the reduction in latency and memory footprint may result from folding a product-code block so that the number of logical rows is smaller than the number of logical columns and so that a grouped-column component codeword is formed from a group of G columns rather than from a single column. In one example, each row may form a row component codeword and each group of G columns may form a grouped-column component codeword. In some examples, this arrangement allows grouped-column decoding to begin after payload information for the smaller row dimension has been received, rather than after buffering a larger unfolded block. In some examples, horizontal folding by a factor of G may reduce the amount of memory used to assemble a decodable block (e.g., by about a factor associated with G), while preserving row-related and grouped-column-related component-code protection for the payload information.

Additionally, in some examples, omitting parity-on-parity (checks-on-checks) may reduce parity overhead and the amount of parity information to be generated, transmitted, buffered, and/or iteratively processed, for example by excluding additional parity bits for protecting parity information, which may reduce implementation complexity, data movement, and memory bandwidth, and thereby reduce area and/or power. In some examples, these effects may be particularly beneficial in high-throughput receiver implementations where iterative soft-decision decoding is employed and where reduced buffering and lower decoding latency are targeted. Further, in some examples, the performance tradeoff associated with omitting parity-on-parity may be acceptable, for example where the folded code operates as an inner code in a layered coding architecture to reduce an error rate to a level that is subsequently handled by an outer code and/or other downstream error-mitigation circuitry.

In some examples, turbo product codes (TPCs) are described herein as illustrative implementations of the folded forward error-correction code technique; however, the techniques described herein are not limited to TPCs. For example, the folding concepts (e.g., logically organizing payload information into rows and columns, forming grouped-column-related codewords from multiple columns, and/or omitting checks-on-checks such as parity-on-parity) may be applied to other forward error-correction code constructions that use (or may be represented using) a multi-dimensional or component-code structure, and/or to other iterative and/or concatenated FEC schemes that operate on groups of bits to reduce buffering, latency, and/or implementation cost. In some examples, the component codes used for row-related and grouped-column-related operations may include any suitable block code (e.g., BCH, Hamming, Reed-Solomon, or other component codes), and the folded arrangement may be adapted accordingly while maintaining one or more of the technical effects described herein.

### Select examples

Example 1 provides a forward error correction decoder to decode encoded data encoded in accordance with a folded error-correction code, the forward error correction decoder including I/O circuitry to receive the encoded data including payload information and parity information, where: the payload information is logically organized as a first number of columns and a second number of rows, where the first number is greater than the second number, and the parity information includes row parity information and grouped-column parity information, where the grouped-column parity information is for a group of two or more of the columns; and decoder circuitry to: decode, based on the grouped-column parity information for the group, a codeword including bits from the columns in the group, and output an error pattern for the payload information based on decoding the codeword.

Example 2 provides the forward error correction decoder of example 1, where: the parity information excludes additional parity bits for protecting the row parity information or the grouped-column parity information.

Example 3 provides the forward error correction decoder of examples 1 or 2, where: the row parity information and the grouped-column parity information include the same number of parity bits.

Example 4 provides the forward error correction decoder of example 3, where: the group includes G columns, and an individual row of the rows has the same number of bits as the G columns.

Example 5 provides the forward error correction decoder of example 4, where the bits from the columns in the group are first bits, and where: a row codeword including second bits from the individual row and the codeword including the first bits from the columns in the group are encoded in accordance with the same component code.

Example 6 provides the forward error correction decoder of any one of examples 1-5, where the first number of columns is K, and where: the group includes G columns, and G is an integer greater than 1 and smaller than or equal to half of K.

Example 7 provides the forward error correction decoder of any one of examples 1-6, where: at least two columns in the group are separated by one or more intervening columns.

Example 8 provides the forward error correction decoder of example 7, where: the columns in the group are selected according to a stride greater than one across the first number of columns.

Example 9 provides the forward error correction decoder of any one of examples 1-8, where: the decoder circuitry is to start decoding the codeword including bits from the columns in the group in response to receipt of payload information for the second number of rows.

Example 10 provides an optical module to process encoded data encoded in accordance with a folded error-correction code, the optical module including optical receiver circuitry to receive optical signals and derive the encoded data from the optical signals, where the encoded data includes data bits and parity bits, where: the data bits include rows of a first length and columns of a second length, where the first length is greater than the second length, and the parity bits include row parity bits and grouped-column parity bits, where the grouped-column parity bits are for a group of two or more of the columns; and a forward error correction decoder to: decode, based on the grouped-column parity bits for the group, a codeword including bits from the columns in the group, and output an error pattern for the data bits based on decoding the codeword.

Example 11 provides the optical module of example 10, where: the parity bits exclude additional parity bits for protecting the row parity bits or the grouped-column parity bits.

Example 12 provides the optical module of examples 10 or 11, where: the row parity bits and the grouped-column parity bits include the same number of parity bits.

Example 13 provides the optical module of example 12, where: the group includes G columns, and an individual row of the rows has the same number of bits as G columns.

Example 14 provides the optical module of example 13, where the bits from the columns of the group are first bits, and where: a row codeword including second bits from the individual row and the codeword including the first bits from the columns in the group are based on the same component code.

Example 15 provides the optical module of any one of examples 10-14, where: the number of columns of the data bits is K and the group includes G columns, G being an integer greater than 1 and smaller than or equal to half of K.

Example 16 provides the optical module of any one of examples 10-15, where: at least two columns in the group are separated by one or more intervening columns.

Example 17 provides the optical module of example 16, where: the columns in the group are selected according to a stride greater than one across the columns.

Example 18 provides the optical module of any one of examples 10-17, where: the forward error correction decoder is to start decoding the codeword including bits from the columns in the group in response to receipt of the data bits for a number of the rows equal to the second length.

Example 19 provides an optical module to process encoded data encoded in accordance with a folded error-correction code, the optical module including means for receiving optical signals and deriving encoded data from the optical signals, where the encoded data includes data bits and parity bits, where: the data bits include rows of a first length and columns of a second length, where the first length is greater than the second length; and the parity bits include row parity bits and grouped-column parity bits, where the grouped-column parity bits are for a group of two or more of the columns; and means for: decoding, based on the grouped-column parity bits for the group, a codeword including bits from the columns in the group, and outputting an error pattern for the data bits based on decoding the codeword.

Example 20 provides the optical module of example 19, where: the parity bits exclude additional parity bits for protecting the row parity bits or the grouped-column parity bits.

Example 21 provides the optical module of examples 19 or 20, where: the parity bits include the same number of the row parity bits as the grouped-column parity bits.

Example 22 provides the optical module of example 21, where: the group includes G columns, and an individual row of the rows has the same number of bits as G columns.

Example 23 provides the optical module of example 22, where: a row codeword including bits from the individual row and the codeword including bits from the columns in the group are based on the same component code.

Example 24 provides the optical module of any one of examples 19-23, where: a number of columns of the data bits is K, and the group includes G columns, G being an integer greater than 1 and smaller than or equal to half of K.

Example 25 provides the optical module of any one of examples 19-24, where: at least two columns in the group are separated by one or more intervening columns.

Example 26 provides the optical module of example 25, where: the columns in the group are selected according to a stride greater than one across the columns.

Example 27 provides the optical module of any one of examples 19-26, where: the means for decoding the codeword is to: start decoding the codeword including the bits from the columns in the group in response to receipt of the data bits for a number of the rows equal to the second length.

Example 28 provides the optical module of example 19, where the data bits are first data bits, the row parity bits are first row parity bits, the grouped-column parity bits are first grouped-column parity bits, the group is a first group, and where the optical module further includes means for encoding second data bits to generate second encoded data including the second data bits and second parity bits, where the second parity bits include second row parity bits, and second grouped-column parity bits for a second group of two or more columns of the second data bits.

Example 29 provides a method of decoding encoded data encoded in accordance with a folded error-correction code, the method including receiving the encoded data including payload information and parity information, where: the parity information includes row parity information for a row of the payload information, and column parity information for a group of two or more columns of the payload information, where the row has more bits than one of the columns; decoding, based on the column parity information for the group, a codeword including bits from the columns in the group; and outputting an error pattern for the payload information based on the decoding of the codeword.

Example 30 provides the method of example 29, where: the parity information excludes additional parity bits for protecting the row parity information or the column parity information.

Example 31 provides the method of examples 29 or 30, where: the row parity information and the column parity information include the same number of parity bits.

Example 32 provides the method of example 31, where: the group includes G columns, and where a row of the payload information has the same number of bits as G columns.

Example 33 provides the method of example 32, where: a number of columns of the payload information is K, and G is an integer greater than 1 and smaller than or equal to half of K.

Example 34 provides the method of any one of examples 29-33, where the payload information is first payload information, the row is a first row, the row parity information is first row parity information, the column parity information is first column parity information, the group is a first group, the two or more columns are two or more first columns, and where the method includes encoding second payload information to generate second encoded data including the second payload information and second parity information, where the second parity information includes second row parity information for a second row of the second payload information, and second column parity information for a second group of two or more second columns of the second payload information, where the second row has more bits than one of the second columns.

Example 35 provides the method of any one of examples 29-34, where: at least two columns in the group are separated by one or more intervening columns.

Example 36 provides the method of example 35, where: the columns in the group are selected according to a stride greater than one across the columns.

Example 37 provides the method of any one of examples 29-36, further including starting the decoding of the codeword in response to receipt of payload information for a number of the rows that is smaller than a number of the columns.

Example 38 provides a forward error correction encoder to encode payload information in accordance with a folded error-correction code, the forward error correction encoder including I/O circuitry to receive the payload information; circuitry to logically organize the payload information as a first number of columns and a second number of rows, where the first number is greater than the second number; encoder circuitry to: generate row parity information for a row of the second number of rows, and generate grouped-column parity information for a group of two or more of the columns of the first number of columns; and output circuitry to output encoded data including the payload information and parity information, where the parity information includes the row parity information and the grouped-column parity information.

Example 39 provides the forward error correction encoder of example 38, where: the encoder circuitry is to omit generating parity bits for one or more parity columns including the row parity information and for one or more parity rows including the grouped-column parity information.

Example 40 provides the forward error correction encoder of examples 38 or 39, where: the row parity information and the grouped-column parity information include the same number of parity bits.

Example 41 provides the forward error correction encoder of any one of examples 38-40, where: the group includes G columns, and an individual row of the second number of rows has the same number of bits as G columns.

Example 42 provides the forward error correction encoder of example 41, where: a row codeword including bits from the individual row and a grouped-column codeword including bits from the columns in the group are encoded in accordance with a same component code.

Example 43 provides the forward error correction encoder of any one of examples 38-42, where: the first number of columns is K, and the group includes G columns, where G is an integer greater than 1 and smaller than or equal to half of K.

Example 44 provides the forward error correction encoder of any one of examples 38-43, where: at least two columns in the group are separated by one or more intervening columns.

Example 45 provides the forward error correction encoder of example 44, where: the columns in the group are selected according to a stride greater than one across the first number of columns.

Example 46 provides the forward error correction encoder of any one of examples 38-45, where: the encoder circuitry is to start generating the grouped-column parity information for the group in response to receipt of payload information for the second number of rows.

Example 47 provides a method of encoding payload information in accordance with a folded error-correction code, the method including logically organizing payload information as a first number of columns and a second number of rows, where the first number is greater than the second number; generating row parity information for a row of the second number of rows; generating grouped-column parity information for a group of two or more of the columns of the first number of columns; and outputting encoded data including the payload information and parity information, where the parity information includes the row parity information and the grouped-column parity information.

Example 48 provides the method of example 47, where: generating the row parity information includes omitting parity bits for one or more parity columns including the row parity information, and generating the grouped-column parity information includes omitting parity bits for one or more parity rows including the grouped-column parity information.

Example 49 provides the method of examples 47 or 48, where: the row parity information and the grouped-column parity information include the same number of parity bits.

Example 50 provides the method of any one of examples 47-49, where: the group includes G columns, and an individual row of the second number of rows has the same number of bits as G columns.

Example 51 provides the method of example 50, where: a row codeword including bits from the individual row and a grouped-column codeword including bits from the columns in the group are encoded in accordance with the same component code.

Example 52 provides the method of any one of examples 47-51, where: the first number of columns is K, and the group includes G columns, where G is an integer greater than 1 and smaller than or equal to half of K.

Example 53 provides the method of any one of examples 47-52, where: at least two columns in the group are separated by one or more intervening columns.

Example 54 provides the method of example 53, where: the columns in the group are selected according to a stride greater than one across the first number of columns.

Example 55 provides the method of any one of examples 47-54, further including starting to generate the grouped-column parity information for the group in response to receipt of payload information for the second number of rows.

### Variations and other notes

The detailed description, such as the "Select examples" section, provides various examples of the embodiments disclosed herein.

As used herein, the term "coupled to" or "coupled with" refers to a relationship between electronic components or circuit elements wherein the components are in electronic communication with one another and capable of transmitting and/or receiving electrical signals between them. The term "coupled to" does not require a direct physical or electrical connection between the coupled components. Rather, "coupled to" can encompass arrangements where the components are connected through one or more intervening elements, components, circuits, or transmission paths. For example, a first component may be "coupled to" a second component through intermediate components such as resistors, capacitors, inductors, transistors, logic gates, buses, transformers, or other electronic components, or through intermediate transmission paths, while still maintaining the capability for electronic communication between the first and second components.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

For purposes of explanation, specific numbers, materials, and configurations are set forth in order to provide a thorough understanding of the illustrative implementations. However, it will be apparent to one skilled in the art that the present disclosure may be practiced without the specific details and/or that the present disclosure may be practiced with only some of the described aspects. In other instances, well-known features are omitted or simplified in order not to obscure the illustrative implementations.

Further, references are made to the accompanying drawings that form a part hereof, and in which are shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the disclosed subject matter. However, the order of description should not be construed as to imply that these operations are necessarily order-dependent. In particular, these operations may not be performed in the order of presentation. Operations described may be performed in a different order from the described embodiment. Various additional operations may be performed or described operations may be omitted in additional embodiments.

For the purposes of the present disclosure, the phrase "A or B" or the phrase "A and/or B" means (A), (B), or (A and B). For the purposes of the present disclosure, the phrase "A, B, or C" or the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicates that different instances of like objects are being referred to and are not intended to imply that the objects so described must be in a given sequence, either temporally, spatially, in ranking, or in any other manner.

In the following detailed description, various aspects of the illustrative implementations will be described using terms commonly employed by those skilled in the art to convey the substance of their work to others skilled in the art.

The terms "substantially," "close," "approximately," "near," and "about," generally refer to being within +/- 20% of a target value as described herein or as known in the art. Similarly, terms indicating orientation of various elements, e.g., "coplanar," "perpendicular," "orthogonal," "parallel," or any other angle between the elements, generally refer to being within +/- 5-20% of a target value as described herein or as known in the art.

In addition, the terms "comprise," "comprising," "include," "including," "have," "having," or any other variation thereof, are intended to cover a non-exclusive inclusion. For example, a method, process, or device, that comprises a list of elements is not necessarily limited to only those elements but may include other elements not expressly listed or inherent to such method, process, or device. Also, the term "or" refers to an inclusive "or" and not to an exclusive "or."

The systems, methods, and devices of this disclosure each have several innovative aspects, no single one of which is solely responsible for all desirable attributes disclosed herein. Details of one or more implementations of the subject matter described in this specification are set forth in the description and the accompanying drawings.
The following is a list of further preferred embodiments of the invention:
1. A forward error correction decoder to decode encoded data encoded in accordance with a folded error-correction code, the forward error correction decoder comprising:
   input/output (I/O) circuitry to receive the encoded data comprising payload information and parity information, wherein:
      the payload information is logically organized as a first number of columns and a second number of rows, wherein the first number is greater than the second number, and
      the parity information comprises row parity information and grouped-column parity information, wherein the grouped-column parity information is for a group of two or more of the columns; and
   decoder circuitry to:
      decode, based on the row parity information and the grouped-column parity information for the group, a codeword comprising bits from the columns in the group, and
      output an error pattern for the payload information based on decoding the codeword.
2. The forward error correction decoder of embodiment 1, wherein:
   the parity information excludes additional parity bits for protecting the row parity information or the grouped-column parity information.
3. The forward error correction decoder of embodiment 1, wherein:
   the row parity information and the grouped-column parity information comprise a same number of parity bits.
4. The forward error correction decoder of embodiment 3, wherein:
   the group comprises G columns, and
   an individual row of the rows has a same number of bits as the G columns.
5. The forward error correction decoder of embodiment 4, wherein the bits from the columns in the group are first bits, and wherein:
   a row codeword comprising second bits from the individual row and the codeword comprising the first bits from the columns in the group are encoded in accordance with a same component code.
6. The forward error correction decoder of embodiment 1, wherein the bits from the columns in the group are first bits, and wherein:
   a row codeword comprising second bits from a row of the rows is encoded in accordance with a first component code, and
   the codeword comprising the first bits from the columns in the group is encoded in accordance with a second component code different from the first component code.
7. The forward error correction decoder of embodiment 1, wherein the first number of columns is K, and wherein:
   the group comprises G columns, and
   G is an integer greater than 1 and smaller than or equal to half of K.
8. The forward error correction decoder of embodiment 1, wherein:
   at least two columns in the group are separated by one or more intervening columns.
9. The forward error correction decoder of embodiment 8, wherein:
   the columns in the group are selected according to a stride greater than one across the first number of columns.
10. The forward error correction decoder of embodiment 1, wherein:
   the decoder circuitry is to start decoding the codeword comprising the bits from the columns in the group in response to receipt of the payload information for the second number of rows.
11. An optical module to process encoded data encoded in accordance with a folded error-correction code, the optical module comprising:
   means for receiving optical signals and deriving the encoded data from the optical signals, wherein the encoded data comprises data bits and parity bits, wherein:
      the data bits comprise rows of a first length and columns of a second length, wherein the first length is greater than the second length; and
      the parity bits comprise row parity bits and grouped-column parity bits, wherein the grouped-column parity bits are for a group of two or more of the columns; and
   means for:
      decoding, based on the grouped-column parity bits for the group, a codeword comprising bits from the columns in the group, and
      outputting an error pattern for the data bits based on decoding the codeword.
12. The optical module of embodiment 11, wherein:
   the parity bits exclude additional parity bits for protecting the row parity bits or the grouped-column parity bits.
13. The optical module of embodiment 11, wherein:
   the parity bits comprise a same number of the row parity bits as the grouped-column parity bits.
14. The optical module of embodiment 13, wherein:
   the group comprises g columns, and
   an individual row of the rows has a same number of bits as the g columns.
15. The optical module of embodiment 14, wherein the bits from the columns of the group are first bits, and wherein:
   a row codeword comprising second bits from the individual row and the codeword comprising the first bits from the columns in the group are based on a same component code.
16. The optical module of embodiment 11, wherein:
   a number of columns of the data bits is k, and
   the group comprises g columns, g being an integer greater than 1 and smaller than or equal to half of k.
17. The optical module of embodiment 11, wherein:
   at least two columns in the group are separated by one or more intervening columns.
18. The optical module of embodiment 11, wherein:
   the means for decoding the codeword is to: start decoding the codeword comprising the bits from the columns in the group in response to receipt of the data bits for a number of the rows equal to the second length.
19. The optical module of embodiment 11, wherein the data bits are first data bits, the row parity bits are first row parity bits, the grouped-column parity bits are first grouped-column parity bits, the group is a first group, and wherein the optical module further comprises:
   means for encoding second data bits to generate second encoded data comprising the second data bits and second parity bits, wherein the second parity bits comprise:
   second row parity bits, and
   second grouped-column parity bits for a second group of two or more columns of the second data bits.
20. The optical module of embodiment 11, wherein:
   the means for decoding the codeword is to: iteratively decode row-related codewords and grouped-column-related codewords over two or more iterations, wherein an individual iteration comprises decoding the row-related codewords based on the row parity bits and decoding the grouped-column-related codewords based on the grouped-column parity bits.
21. A forward error correction encoder to encode payload information in accordance with a folded error-correction code, the forward error correction encoder comprising:
   input/output (I/O) circuitry to receive the payload information;
   circuitry to logically organize the payload information as a first number of columns and a second number of rows, wherein the first number is greater than the second number;
   encoder circuitry to:
      generate row parity information for a row of the second number of rows, and
      generate grouped-column parity information for a group of two or more of the columns of the first number of columns; and
   output circuitry to output encoded data comprising the payload information and parity information, wherein the parity information comprises the row parity information and the grouped-column parity information.
22. The forward error correction encoder of embodiment 21, wherein:
   the encoder circuitry is to omit generating parity bits for one or more parity columns comprising the row parity information and for one or more parity rows comprising the grouped-column parity information.

## Claims

1. A forward error correction decoder to decode encoded data encoded in accordance with a folded error-correction code, the forward error correction decoder comprising:
input/output (I/O) circuitry to receive the encoded data comprising payload information and parity information, wherein:
the payload information is logically organized as a first number of columns and a second number of rows, wherein the first number is greater than the second number, and
the parity information comprises row parity information and grouped-column parity information, wherein the grouped-column parity information is for a group of two or more of the columns; and
decoder circuitry to:
decode, based on the row parity information and the grouped-column parity information for the group, a codeword comprising bits from the columns in the group, and
output an error pattern for the payload information based on decoding the codeword.

2. The forward error correction decoder of claim 1, wherein:
the parity information excludes additional parity bits for protecting the row parity information or the grouped-column parity information.

3. The forward error correction decoder of one of claims 1 or 2, wherein:
the row parity information and the grouped-column parity information comprise a same number of parity bits.

4. The forward error correction decoder of claim 3, wherein:
the group comprises G columns, and
an individual row of the rows has a same number of bits as the G columns.

5. The forward error correction decoder of claim 4, wherein the bits from the columns in the group are first bits, and wherein:
a row codeword comprising second bits from the individual row and the codeword comprising the first bits from the columns in the group are encoded in accordance with a same component code.

6. The forward error correction decoder of one of claims 1 to 5, wherein the bits from the columns in the group are first bits, and wherein:
a row codeword comprising second bits from a row of the rows is encoded in accordance with a first component code, and
the codeword comprising the first bits from the columns in the group is encoded in accordance with a second component code different from the first component code.

7. The forward error correction decoder of one of claims 1 to 6, wherein the first number of columns is K, and wherein:
the group comprises G columns, and
G is an integer greater than 1 and smaller than or equal to half of K.

8. The forward error correction decoder of one of claims 1 to 7, wherein:
at least two columns in the group are separated by one or more intervening columns, and/or
wherein:
the columns in the group are selected according to a stride greater than one across the first number of columns.

9. The forward error correction decoder of one of claims 1 to 8, wherein:
the decoder circuitry is to start decoding the codeword comprising the bits from the columns in the group in response to receipt of the payload information for the second number of rows.

10. An optical module to process encoded data encoded in accordance with a folded error-correction code, the optical module comprising:
means for receiving optical signals and deriving the encoded data from the optical signals, wherein the encoded data comprises data bits and parity bits, wherein:
the data bits comprise rows of a first length and columns of a second length, wherein the first length is greater than the second length; and
the parity bits comprise row parity bits and grouped-column parity bits, wherein the grouped-column parity bits are for a group of two or more of the columns; and
means for:
decoding, based on the grouped-column parity bits for the group, a codeword comprising bits from the columns in the group, and
outputting an error pattern for the data bits based on decoding the codeword.

11. The optical module of claim 10, wherein:
the parity bits exclude additional parity bits for protecting the row parity bits or the grouped-column parity bits.

12. The optical module of claim 10 or 11, wherein:
the parity bits comprise a same number of the row parity bits as the grouped-column parity bits, and/or
wherein:
the group comprises g columns, and
an individual row of the rows has a same number of bits as the g columns, and/or
wherein the bits from the columns of the group are first bits, and wherein:
a row codeword comprising second bits from the individual row and the codeword comprising the first bits from the columns in the group are based on a same component code.

13. The optical module of one of claims 10 to 12, wherein:
a number of columns of the data bits is k, and
the group comprises g columns, g being an integer greater than 1 and smaller than or equal to half of k, or
wherein:
at least two columns in the group are separated by one or more intervening columns, or
wherein:
the means for decoding the codeword is to: start decoding the codeword comprising the bits from the columns in the group in response to receipt of the data bits for a number of the rows equal to the second length, or
wherein the data bits are first data bits, the row parity bits are first row parity bits, the grouped-column parity bits are first grouped-column parity bits, the group is a first group, and wherein the optical module further comprises:
means for encoding second data bits to generate second encoded data comprising the second data bits and second parity bits, wherein the second parity bits comprise:
second row parity bits, and
second grouped-column parity bits for a second group of two or more columns of the second data bits, or
wherein:
the means for decoding the codeword is to: iteratively decode row-related codewords and grouped-column-related codewords over two or more iterations, wherein an individual iteration comprises decoding the row-related codewords based on the row parity bits and decoding the grouped-column-related codewords based on the grouped-column parity bits.

14. A forward error correction encoder to encode payload information in accordance with a folded error-correction code, the forward error correction encoder comprising:
input/output (I/O) circuitry to receive the payload information;
circuitry to logically organize the payload information as a first number of columns and a second number of rows, wherein the first number is greater than the second number;
encoder circuitry to:
generate row parity information for a row of the second number of rows, and
generate grouped-column parity information for a group of two or more of the columns of the first number of columns; and
output circuitry to output encoded data comprising the payload information and parity information, wherein the parity information comprises the row parity information and the grouped-column parity information.

15. The forward error correction encoder of claim 14, wherein:
the encoder circuitry is to omit generating parity bits for one or more parity columns comprising the row parity information and for one or more parity rows comprising the grouped-column parity information.
